Europäisches Patentamt

European Patent Office

Office européen des brevets

(19)

(11) Publication number: **0 290 277 B1**

## EUROPEAN PATENT SPECIFICATION

(12)

(45) Date of publication of patent specification: **19.08.92**  (51) Int. Cl.⁵: **H03F 1/26**, H03F 3/343

(21) Application number: **88304135.2**

(22) Date of filing: **06.05.88**

(54) **A low noise integrated active load circuit.**

(30) Priority: **08.05.87 US 47694**

(43) Date of publication of application:
**09.11.88 Bulletin 88/45**

(45) Publication of the grant of the patent:
**19.08.92 Bulletin 92/34**

(84) Designated Contracting States:
**DE ES FR GB IT**

(56) References cited:
**US-A- 3 392 342**
**US-A- 3 500 220**
**US-A- 4 460 872**

**IBM TECHNICAL DISCLOSURE BULLETIN, vol.
13, no. 8, January 1971, pages 2312-2313,
New York, US; C.C. LIU et al.: "Low noise
wide-band amplifier"**

**IEEE JOURNAL OF SOLID-STATE CIRCUITS,
vol. SC-10, no. 6, December 1975, pages
516-524, New York, US; A. BILOTTI et al.:
"Noise characteristics of current mirror
sinks/sources"**

(73) Proprietor: **Hewlett-Packard Company
Mail Stop 20 B-O, 3000 Hanover Street
Palo Alto, California 94304(US)**

(72) Inventor: **Ouan, Ronald
10910 Wunderlich Drive
Cupertino California 95014(US)**

(74) Representative: **Williams, John Francis et al
WILLIAMS, POWELL & ASSOCIATES 34
Tavistock Street
London WC2E 7PB(GB)**

EP 0 290 277 B1

**Description**

Field of the Invention

This invention relates to the field of bipolar integrated circuits. More particularly, this invention relates to the field of low noise active load circuits in bipolar integrated circuits.

Background of the Invention

Electronic noise is an undesirable side effect of the operation of electronic circuits. Device switching and p-n junction operation are common sources of electronic noise in integrated circuits.

It is an object of the present invention to provide an active load circuit for an integrated circuit which has reduced noise introducing properties.

It is another object of the present invention to provide an active load circuit for an integrated circuit which does not appreciably increase the surface of the integrated circuit.

Accordingly, the invention proposes a low noise integrated active load circuit comprising:

a. a first terminal ( );

b. a second terminal ( );

c. a third terminal ( );

d. a first bias resistor having a first resistor terminal and a second resistor terminal said first resistor terminal coupled to said second terminal;

e. a first transistor ($Q_{L1}$) having a first collector, a first base and a first emitter, said first emitter coupled to said first terminal and said first collector coupled to said third terminal; and

f. a plurality of second transistors ( ) each having a second collector, a second base and a second emitter, each of said second emitters coupled to said first terminal, each of said second bases coupled to said first base, to each of said second collectors and to said second resistor terminal.

Preferably the load circuit has a first terminal which is a power supply, a second terminal which is a ground node and a third terminal which loads an external circuit. A first bipolar transistor has its emitter coupled to the first terminal and its collector coupled to the third terminal. A pluraLity of second transistors each have an emitter coupled to the first terminal, base and collector coupled to the base of the first transistor and to a load resistor. The load resistor is also coupled to ground.

Brief Description of the Drawings

The invention will now be described with reference to several exemplary embodiments of the invention illustrated in the accompanying drawings; in which:

Figure 1 is a circuit diagram illustrating a prior art active load and a photodiode preamplifier application circuit.

Figure 2 is a circuit diagram illustrating a prior art method of lowering the noise of Figure 1, but utilizing excess chip area.

Figure 3 is a circuit diagram illustrating a preferred embodiment of the present invention.

Figure 4 is a circuit diagram illustrating an equivalent circuit indicating sources of noise.

Figure 5 is a circuit diagram illustrating an equivalent circuit indicating sources of noise in reference to an AC signal ground.

Figure 6 is a circuit diagram illustrating a single high current gaIn transistor and a noise source.

Figure 7 is a circuit diagram illustrating an equivalent circuit with localized noise sources.

Figure 8 is a circuit diagram illustrating an alternate embodiment of the present invention.

Detailed Description of the Preferred Embodiment

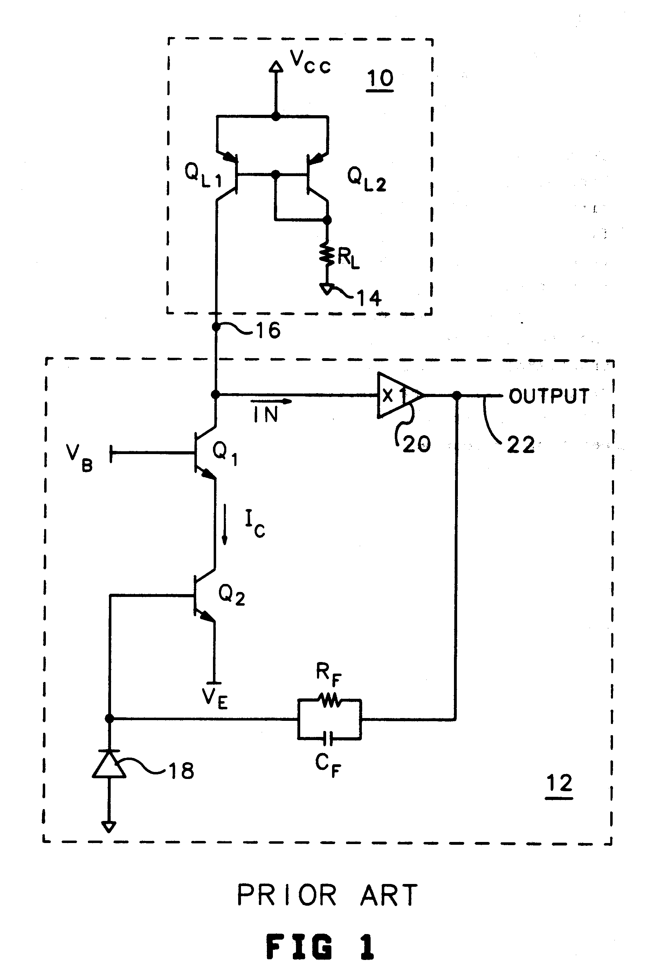

The active load circuit 10 shown in Figure 1 introduces electronic noise into the application circuit 12 that it loads. The active load circuit 10 has a voltage supply $V_{CC}$, load transistor $Q_{L1}$, load transistor $Q_{L2}$, bias resistor $R_L$ and circuit ground 14. $Q_{L1}$ and $Q_{L2}$ are PNP transistors. The emitter of $Q_{L1}$ is coupled to the voltage supply $V_{CC}$. The collector of transistor $Q_{L1}$ is coupled to the loading node 16. The base of transistor $Q_{L1}$ is coupled to the base and collector of transistor $Q_{L2}$ and to one terminal of the resistor $R_L$. The emitter of transistor $Q_{L2}$ is coupled to the voltage supply $V_{CC}$. The other terminal of the resistor $R_L$ is coupled to ground 14.

The application circuit 12 shown in the prior art Figure 1 is a photodiode preamplifier circuit. The anode

2

terminal of the photodiode 18 is coupled to ground 14 and the cathode terminal of the photodiode 18 is coupled to the base of transistor $Q_2$ and to one terminal each of the feedback resistor $R_F$ and the feedback capacitor $C_F$. The emitter of transistor $Q_2$ is coupled to a first biasing voltage level $V_E$. The collector of transistor $Q_2$ is coupled to the emitter of transistor $Q_1$. The base of transistor $Q_1$ is coupled to a second biasing voltage supply $V_B$. The collector of transistor $Q_1$ is coupled to loading node 16 and to the input of the gain-of-one amplifier 20. The output of the amplifier 20 is coupled to the output 22 of the photodiodepreamplifier circuit 12 and to the other terminal of each of the feedback resistor $R_F$ and the feedback capacitor $C_F$. The output 22 is used to drive external circuitry which is not shown.

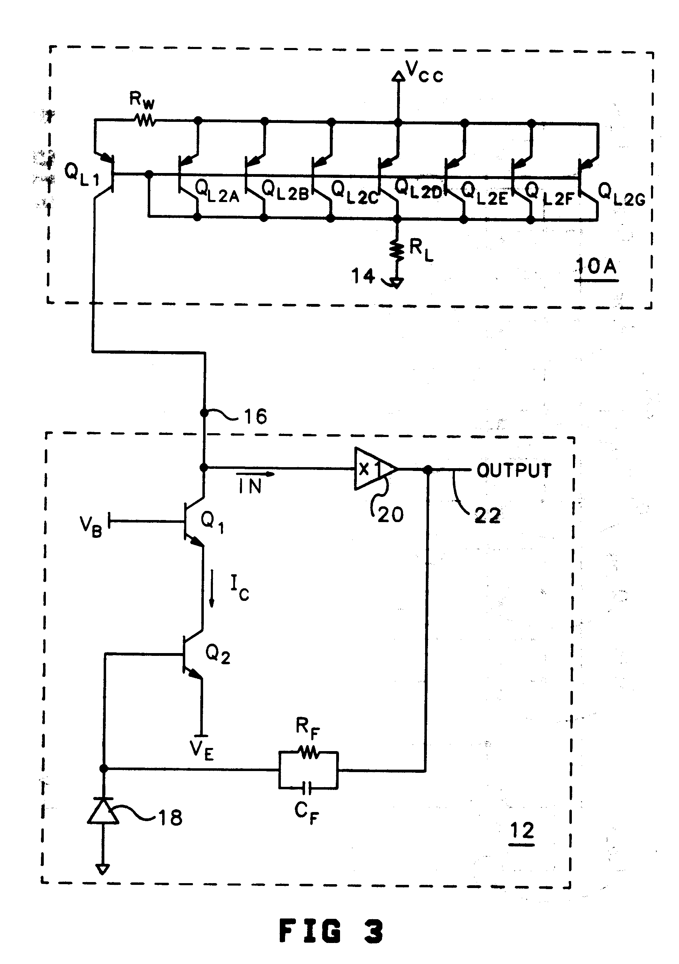

Referring to Figure 2 one can see a technique to reduce the noise introduced by the load circuit. A load resistor $R_L$ replaces the active load circuit 10 of Figure 1 and is coupled between the power supply $V_{CC}$ andthe collector of transistor $Q_1$. Also such a resistive load must typically be a very high resistance, on the order of several hundred k$\Omega$ requiring much surface area on an integrated circuit. The base of transistor $Q_1$ is coupled to a biasing voltage $V_B$ and the emitter is coupled to the collector of transistor $Q_2$. The base of traNsistor $Q_2$ is coupled to an input voltage $V_{IN}$ and the emitter is coupled to a biasing voltage $V_E$.

If the circuit of Figure 2 is designed to require a load current of 5 $\mu$A, the resistor is 76 k$\Omega$. Because the cost of manufacturing an integrated circuit is directly related to the area of the circuit, each of these prior art techniques of reducing noise resulting from an active load is undesirable. Where such techniques have been utilized typically the integrated circuit designer has required the user to attach an external resistor rather than integrating the large resistance into the device.

The preferred embodiment of the present invention shown in Figure 3 is described relative to the same application circuit 12 shown in the prior art circuit of Figure 1. The anode terminal of photodiode 18 is coupled to ground 14 and the cathode terminal of photodiode 18 is coupled to the base of transistor $Q_2$ and to one terminal of feedback resistor $R_F$ and feedback capacitor $C_F$. The emitter of transistor $Q_2$ is coupled to a voltage level $V_E$. The collector of transistor $Q_2$ is coupled to the emitter of transistor $Q_1$. The base of transistor $Q_1$ is coupled to voltage supply $V_B$. The collector of transistor $Q_1$ is coupled to loading node 16 and to the input of the gain-of-one op amp 20. The output of op amp 20 coupled to the output 22 of the photodiode preamplifier circuit 12 and to the other terminal of the feedback resistor $R_F$ and the feedback capacitor $C_F$.

The novel active load circuit 10A of the present invention has a voltage supply $V_{CC}$, load transistor $Q_{L1}$, a plurality of load transistors $Q_{L2A}$, through $Q_{L2G}$, load resistor $R_L$ and circuit ground 14. $Q_{L1}$ and $Q_{L2A}$ through $Q_{L2G}$ are PNP transistors. The emitter of $Q_{L1}$ is coupled to the resistor $R_W$. The resistor $R_W$ is also coupled to the voltage supply $V_{CC}$. The collector of transistor $Q_{L1}$ is coupled to the loading node 16 of circuit 12. The bases of each transistor $Q_{L2A}$ through $Q_{L2G}$ is coupled to each other base and each collector of transistors $Q_{L2A}$ through $Q_{L2G}$ and to one terminal of resistor $R_L$. Each emitter of transistor $Q_{L2A}$ through $Q_{L2G}$ is coupled to voltage supply $V_{CC}$. Each base and collector of each transistor $Q_{L2A}$ through $Q_{L2G}$ is coupled to the base of transistor $Q_{L1}$ and to one terminal of resistor $R_L$. The other terminal of resistor $R_L$ is coupled to ground 14.

The active load circuit 10A of Figure 3 of the present invention operates to reduce the noise introduced into the application circuit 12. As will be clearly understood from the discussion below each component of the active load circuit 10A contributes to the noise introduced into the application circuit 12. The current mirror configuration of the active load circuit 10A reflects the noise generated by the transistors $Q_{L2A}$ through $Q_{L2G}$ and the resistor $R_L$, which are not directly coupled to the application circuit 12, into the application circuit. By forming a plurality of transistors $Q_{L2A}$ through $Q_{L2G}$ such that the current carrying capacity of the side of the current mirror not coupled to the application circuit 12 is greater than the current carrying capacity of the side of the mirror which is so coupled, the amount of noise introduced into the application circuit 12 is reduced proportional to the ratio of those current carrying capacities.

The noise generated in the circuit of Figure 3 responsive to the active load is derived as described below. It is assumed for this derivation that the resistance $R_W$ = $\emptyset\Omega$. The gain, $\beta$, of each of the transistors is very large; assume that $\beta \rightarrow \infty$. Therefore, the noise attributable to each of the base currents is negligible and ignored.

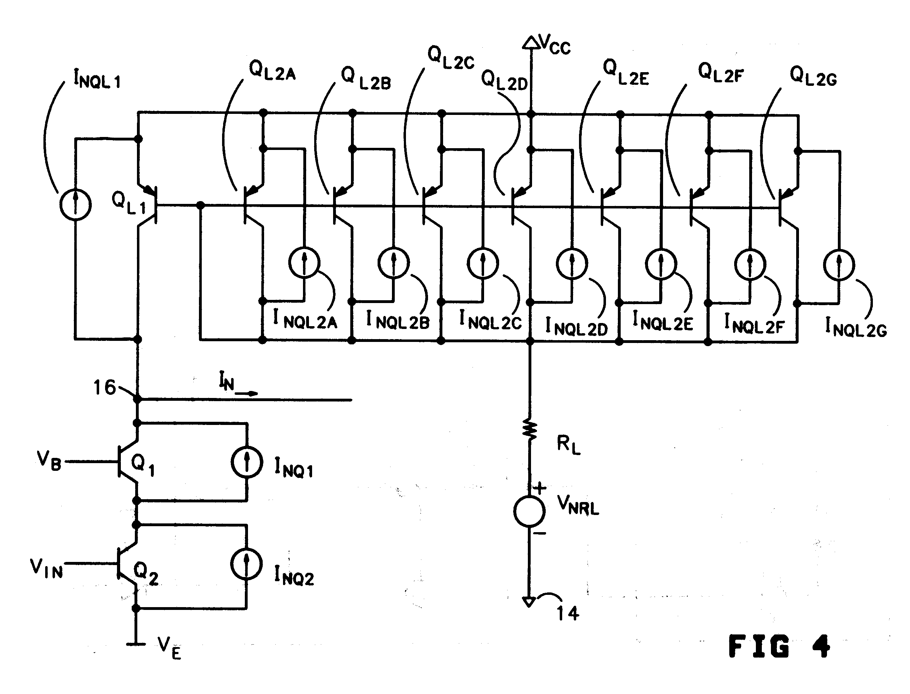

The noise sources which contribute to the noise seen at node 16 and ultimately at the output 22 are shown in Figure 4. The circuit of Figure 4 has the same components as in Figure 3 and are configured in the same fashion. The emitter of $Q_{L1}$ is coupled to the voltage supply $V_{CC}$. The collector of transistor $Q_{L1}$ is coupled to the loading node 16. The base of transistor $Q_{L1}$ is coupled to the base and collector of each transistor $Q_{L2A}$ through $Q_{L2G}$ and to one terminal of the resistor $R_L$. The emitter of each transistor $Q_{L2A}$ through $Q_{L2G}$ is coupled to the voltage supply $V_{CC}$. The other terminal of the resistor $R_L$ is coupled to ground 14.

The collector of NPN transistor $Q_1$ is coupled to node 16, the base to a biasing voltage $V_B$ and the emitter is coupled to the collector of NPN transistor $Q_2$. The base of transistor $Q_2$ is driven by an input voltage $V_{IN}$. $V_{IN}$ is controlled by the remainder of the application circuit and photodiode not shown in Figure 4. The emitter of transistor $Q_2$ is coupled to a biasing voltage supply $V_E$.

The sources of noise are shown in Figure 4 as ten current sources and a voltage source. $I_{NQL1}$ is coupled across transistor $Q_{L1}$ between its collector and emitter. $I_{NQL2A}$ through $I_{NQL2G}$ are coupled across the collector and emitter of each transistor $Q_{L2A}$ through $Q_{L2G}$, respectively. $V_{NRL}$, a noise voltage, is coupled between resistor $R_L$ and ground 14. $I_{NQ1}$ is coupled across transistor $Q_1$ between its collector and emitter. $I_{NQ2}$ is coupled across transistor $Q_2$ between its collector and emitter.

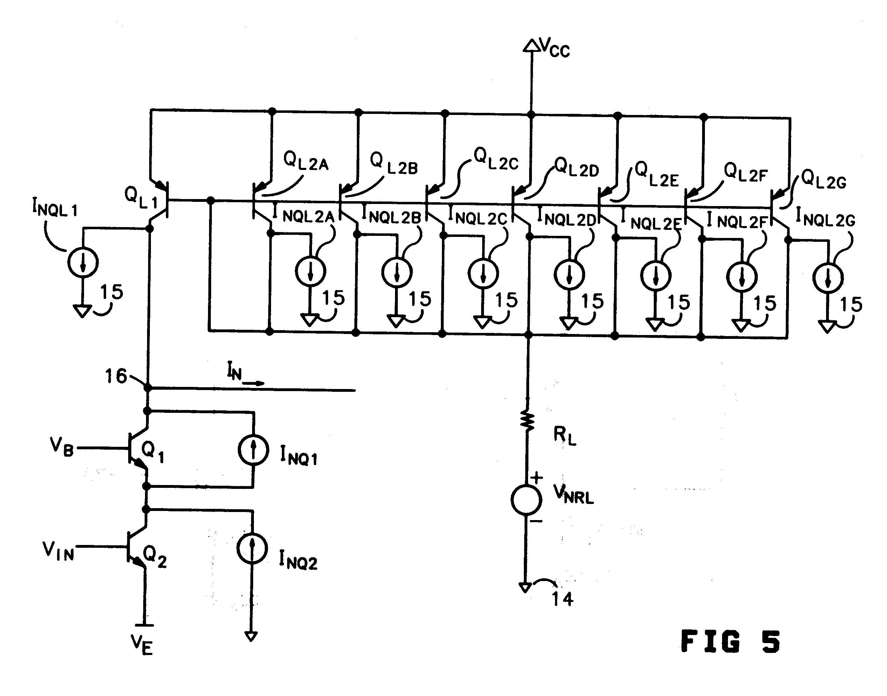

DC voltages represent short circuits to AC signals. Thus, from an AC signal analysis standpoint, any of the noise sources referenced to a DC voltage supply should be referenced to AC signal ground 15. For this reason the circuit analysis for the noise signals relative to the circuit of Figure 3 and Figure 4 as seen at node 16 are shown as modified in Figure 5. The emitter of $Q_{L1}$ is coupled to the voltage supply $V_{CC}$. The collector of transistor $Q_{L1}$ is coupled to the loading node 16. The base of transistor $Q_{L1}$ is coupled to the base and collector of each transistor $Q_{L2A}$ through $Q_{L2G}$ and to one terminal of the resistor $R_L$. The emitter of each transistor $Q_{L2A}$ through $Q_{L2G}$ is coupled to the voltage supply $V_{CC}$. The other terminal of the resistor $R_L$ is coupled to ground 14.

The collector of NPN transistor $Q_1$ is coupled to the node 16, the base to a biasing voltage $V_B$ and the emitter is coupled to the collector of NPN transistor $Q_2$. The base of transistor $Q_2$ is driven by an input voltage $V_{IN}$. $V_{IN}$ is controlled by the application circuit 12 shown in Figure 3 not shown in Figure 5. The emitter of transistor $Q_2$ is coupled to a biasing voltage supply $V_E$.

Each of the noise sources coupled to a DC voltage supply in Figure 4 is shown in Figure 5 to be coupled to the AC signal ground 15. Current source $I_{NQL1}$ is coupled between the collector of transistor $Q_{L1}$ and AC signal ground 15. The current sources $I_{NQL2A}$ through $I_{NQL2G}$ are coupled between the collector of each transistor $Q_{L2A}$ through $Q_{L2G}$, respectively, and AC signal ground 15. Voltage source $V_{NRL}$ is coupled between resistor $R_L$ and circuit ground 14. Current source $I_{NQ1}$ is not coupled to a DC voltage and so remains coupled across the collector and emitter of transistor $Q_1$. Current source $I_{NQ2}$ is coupled between the collector of transistor $Q_2$ and AC signal ground 15.

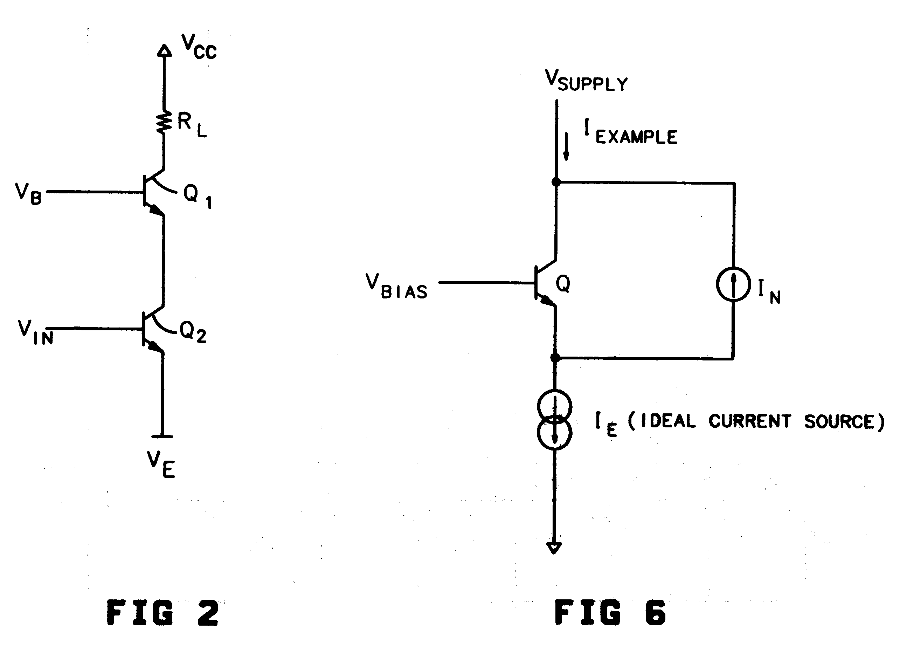

Since $\beta$ for $Q_1$ is large the noise introduced by $Q_1$ is cancelled out. Referring to Figure 6, the collector of transistor Q is coupled to a supply voltage $V_{supply}$. The emitter of transistor Q is coupled to an ideal current source $I_E$. Transistor $Q_2$ is assumed to operate as the ideal current source $I_E$. The ideal current source is coupled to ground. A biasing voltage $V_{bias}$ is coupled to the base. A current source, $I_N$, (i.e. $I_N$ noise current source) is shown coupled between the emitter and collector of the transistor Q. Applying Kirchoff's current law and the basic fundamentals of bipolar transistors yields the result that the current $I_{example}$ is equal to the sum of the noise signal $I_N$ and $\alpha_Q * I_N$ as shown by:

$$I_{example} = - I_N + ( \alpha * I_N ) + ( \alpha * I_E)$$

Because $\beta \rightarrow \infty$, $\alpha \simeq 1$.
Therefore, $I_{example} \simeq I_E$.
Note that $I_N$ is cancelled.

For this reason, the noise attributable to transistor $Q_1$, $I_{NQ1}$, has no effect on the total noise attributable to the circuit active load $I_N$ shown in Figure 5.

Referring again to Figure 5, $Q_1$ is in common base configuration. Therefore, the emitter current is approximately equal to the collector current in $Q_1$. The emitter current in $Q_1$ is exactly equal to the collector current in $Q_2$. Thus, the noise attributable to $Q_2$ is reflected into node 16. The noise attributable to $Q_{L1}$ is coupled to node 16. The voltage noise source $V_{NRL}$ may be configured as a current source, relative to the resistance of resistor $R_L$, which is applied to the collector of transistor $Q_{L2A}$ through $Q_{L2G}$. Because QLI and $Q_{L2A}$ through $Q_{L2G}$ are each configured as a one-toone current mirror the noise attributable to $QL2_A$ through $Q_{L2G}$ and to the resistor $R_L$ are also reflected into node 16.

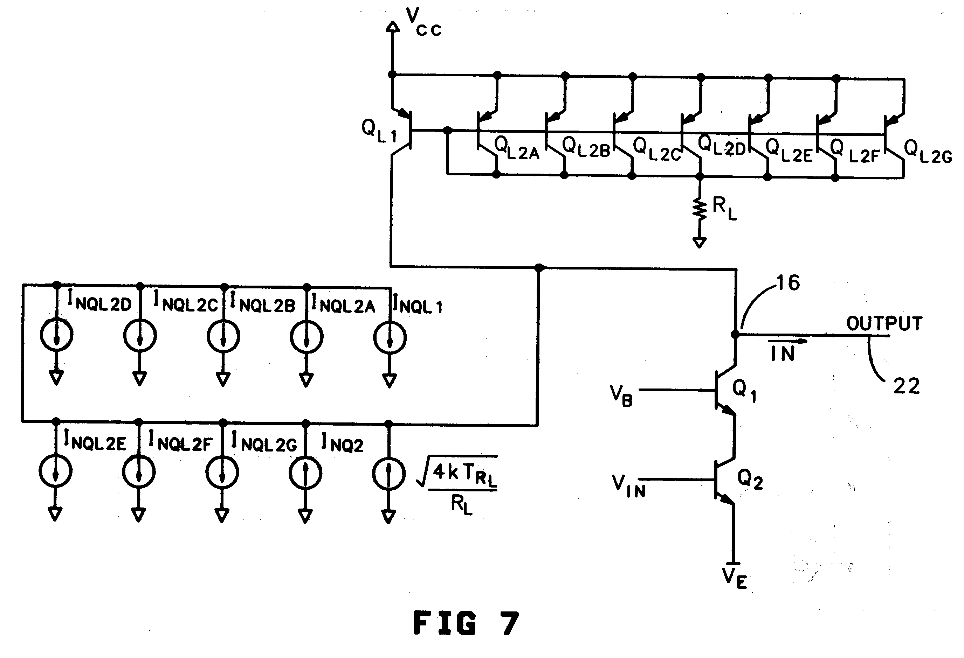

All the noise sources in the circuit of Figure 3 relative to the active load can be analyzed as if they were applied to node 16 as shown is Figure 7. The emitter of $Q_{L1}$ is coupled to the voltage supply $V_{CC}$. The collector of transistor $Q_{L1}$ is coupled to the loading node 16 of circuit 12. The base of transistor $Q_{L1}$ is coupled to each base and collector of transistor $Q_{L2A}$ through $Q_{L2G}$ and to one terminal of the resistor $R_L$. The emitter of each transistor $Q_{L2A}$ through $Q_{L2G}$ is coupled to the voltage supply $V_{CC}$. The other terminal of the resistor $R_L$ is coupled to ground 14.

The collector of NPN transistor $Q_1$ is coupled to the node 16, the base to a biasing voltage $V_B$ and the emitter is coupled to the collector of NPN transistor $Q_2$. The base of transistor $Q_2$ is driven by an input voltage $V_{IN}$. $V_{IN}$ is controlled by the remainder of the application circuit and photodiode not shown in Figure 7. The emitter of transistor $Q_2$ is coupled to a DC voltage supply $V_E$.

Ten current supplies are thus shown coupled between node 16 and AC ground 15. Those current supplies are $I_{NQL1}$, $I_{NQL2A}$ through $I_{NQL2G}$, $I_{NQ2}$ and $\sqrt{4kTR_L}$ / $R_L$ which are coupled between the node 16 and AC signal ground 15. By applying Ohm's law and relying upon the fact that $R_L \gg 1/g_{mQL2}$ the noise current attributable to the resistor $R_L$ is approximately equal to the square root of $4kTR_L$ divided by $R_L$.

Because the introduction of noise is a random occurrence the statistical value of the noise appearing at node 16 is given by the square root of the sum of the squares of each individual noise source. Thus, the noise IN is described by the equation:

$$I_N = \left\{ I_{NQ1}^2 + I_{NQL1}^2 + (I_{NQL2A}^2 + I_{NQL2B}^2 + I_{NQL2C}^2 + I_{NQL2D}^2 + I_{NQL2E}^2 + I_{NQL2F}^2 + I_{NQL2G}^2) / 7^2 + \frac{4kTR_L}{R_L^2} \cdot \frac{1}{7^2} \right\}^{\frac{1}{2}}$$

Because the transistors $Q_{L2A}$ through $Q_{L2G}$ are designed to be identical the current through each of the transistors $Q_{L2A}$ through $Q_{L2G}$ must be identical so that $I_{NQL2A} = I_{NQL2B} = \cdots = I_{NQL2G}$. Therefore, the equation above can be written as:

$$I_N = \left\{ I_{NQ1}^2 + I_{NQL1}^2 + \frac{7(I_{NQL2A})^2}{7^2} + \frac{4kTR_L}{R_L} \cdot \frac{1}{7^2} \right\}^{\frac{1}{2}}$$

or in general;

$$I_N = \left\{ I_{NQ1}^2 + I_{NQL1}^2 + \frac{n(I_{NQL2A})^2}{n^2} + \frac{4kTR_L}{R_L} \cdot \frac{1}{n^2} \right\}^{\frac{1}{2}}$$

in the above n = 7

Because of the current mirror configuration of the active load circuit, the current through each of the transistors $Q_{L2A}$ through $Q_{L2G}$ is identical to the current through transistor $Q_{L1}$. It is clear, therefore, that the noise power for each of the transistors $Q_{L2A}$ through $Q_{L2G}$ is reduced by $1/7^2$ (the number of transistors $Q_{L2A}$ through $Q_{L2G}$) upon being reflected through the current mirror of transistor $Q_{L1}$ and $Q_{L2A}$ through $Q_{L2G}$. For the same reason, the noise power associated with resistor $R_L$ is also reduced by $1/7^2$.

If $I_{QL1}$ is selected to be $5\mu A$ and $V_{CC} = 5V$, $R_L$ must equal 122.9KΩ. $I_N = 1.85$ pA/$\sqrt{Hz}$. For a similar $5\mu A$ current the prior art circuit would have a noise current $I_N \approx 2.19$ pA/$\sqrt{Hz}$. This is 84% of the noise from the active load circuit of the prior art. The noise was lowered by 1.5 dB. Note by increasing n noise ($I_N$) will decrease.

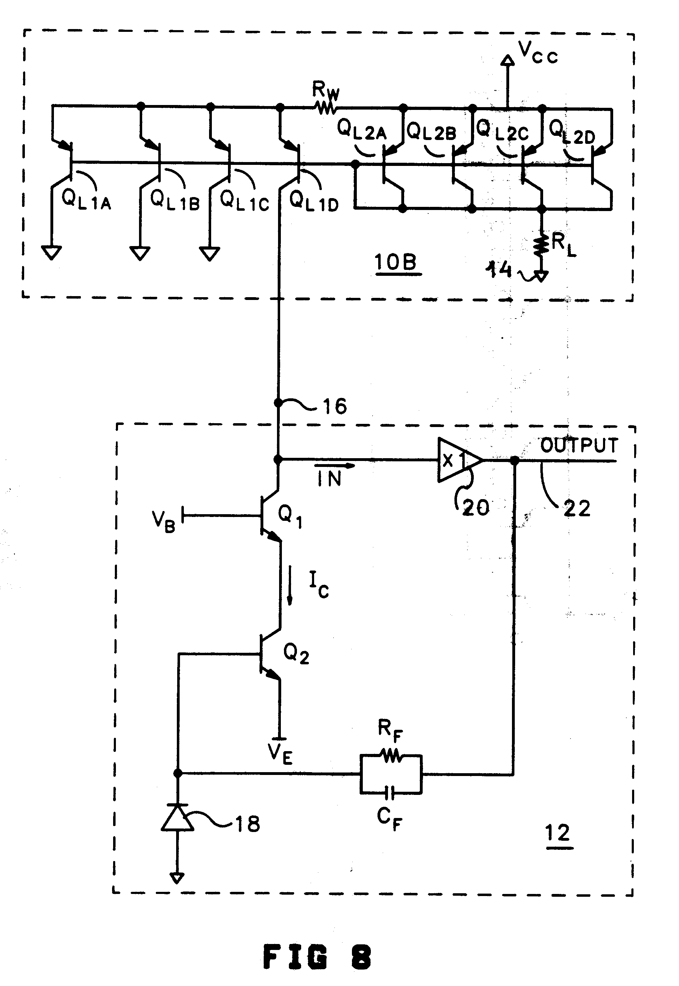

An alternative embodiment of the present invention is shown in Figure 8. The circuit of Figure 8 utilizes the same application circuit 12 as used in Figure 1 and Figure 3. The active load circuit shown in Figure 8 includes a voltage supply $V_{CC}$ a plurality of transistors $Q_{L1A}$ through $Q_{L1D}$, a plurality of transistors $Q_{L2A}$ through $Q_{L2D}$, a load resistor $R_L$, a biasing resistor $R_W$ and a circuit ground 14. Each of the transistors $Q_{L1A}$ through $Q_{L1D}$ and $Q_{L2A}$ through $Q_{L2D}$ are PNP transistors. The emitter of each of the transistors $Q_{L2A}$ through $Q_{LID}$ is coupled to a terminal of biasing resistor $R_W$. Each collector of transistors $Q_{L1A}$ through $Q_{L1C}$ is coupled to ground. The collector of transistor $Q_{L1D}$ is coupled to loading point 16. The base of each of the transistors $Q_{L1A}$ through $Q_{L1D}$ is coupled to each base and each collector of transistor $Q_{L2A}$ through $Q_{L2D}$. The emitter of each of the transistors $Q_{L2A}$ through $Q_{L2D}$ is coupled to the second terminal of biasing resistor

5

$R_W$ and to the voltage supply $V_{CC}$. The collector of each of the transistors $Q_{L2A}$ through $Q_{L2D}$ is coupled to resistor $R_L$. Resistor $R_L$ is also coupled to circuit ground 14. Each of the transistors $Q_{L1A}$ through $Q_{L1D}$ and $Q_{L2A}$ through $Q_{L2D}$ are preferably designed to be identical.

The same assumptions and reasoning used to derive the noise power factor $I_N$ in the preferred embodiment circuit of Figures 3-7 are applied to derive the noise power factor for the alternate embodiment of the present invention shown in Figure 8.

A noise power source is coupled across each of the transistors $Q_{L1A}$ through $Q_{L1D}$, $Q_{L2A}$ through $Q_{L2D}$, $Q_1$ and $Q_2$. As described above, the noise source across $Q_1$ has no effect on the output of the circuit due to the high beta of the transistors. Two voltage noise sources are coupled in series with resistor $R_W$ and resistor $R_L$, respectively. Each of the noise sources is reference to a DC voltage level and as such can be analyzed with reference to an AC signal ground 16. The transconductance of the circuit is affected by the value of biasing resistor $R_W$. The current through each transistor $Q_{L2A}$ through $Q_{L2D}$ is $25\mu A$. The current through each transistor $Q_{L2}$ is greater than the current through each transistor $Q_{L1}$ because of the biasing resistor $R_W$.

The transconductance of the transistors $Q_{L1A}$ through $Q_{L1D}$, $g_{mQL1}$, is $20\mu A/kT/q$. The transconductance of the transistors $Q_{L2A}$ through $Q_{L2D}$, $g_{mQL2}$, is $100\mu A/kT/q$. The current $I_{NQ2}$ is the sum of the noise through each of the transistors $Q_{L2A}$ through $Q_{L2D}$. The noise current for the circuit of Figure 8 is:

$$I_N = \left\{ 2qI_{NQ1} + 2qI_{NRL} \cdot U^2 + \frac{4kTR_L}{R_L^2} \cdot U^2 + (I_A)^2 \right\}^{\frac{1}{2}},$$

$$I_A^2 = \frac{4kTRW}{(R_W + \frac{1}{g_{mQL1}})^2} \cdot \frac{1}{n^2} + \frac{n-1}{n^2} 2qI_{NQL1D} \left(\frac{R_W}{R_W + \frac{1}{g_{mQL1}}}\right)^2 +$$

$$2qI_{NQL1D} \left(1 - \frac{R_W}{R_W + \frac{1}{g_{mQL1}}} \cdot \frac{1}{n}\right)^2,$$

$$U = \left[\frac{\frac{1}{y}}{1 + \frac{g_{mQL2} \cdot R_W}{y}}\right] \cdot \frac{1}{n},$$

$$y = \frac{g_{mQL1}}{g_{mQL2}}$$

where n = number of transistors $Q_{L1}$ and $Q_{L2}$.

In Figure 8, n = 4.

If the collector current through each transistor $Q_{L2A}$ to $Q_{L2D}$ = $25\mu A$ then by setting $R_L$ = $43K\Omega$ and $V_{CC}$ = 5v, with $R_W$ = $2000\Omega$ then the collector current through transistor $Q_{L1D}$ = $5\mu A$. Thus, $I_N$ = 1.69 pA/$\sqrt{Hz}$. This is 77% of the noise current in the prior art circuit. This is a 2.25 dB reduction.

It is clear from the foregoing discussion that the noise introduced from the active load can be reduced by increasing the number of transistors in parallel in the active load circuit.

The present invention may be practiced without identically duplicating the resistor or transistor values or without duplicating the number of parallel load transistors show in the examples above. Many alternative implementations maybe utilized which embody the basis of the present invention.

It is important that the bipolar transistor voltage $V_{BE}$ be matched for each of the transistors $Q_{L1A}$ through $Q_{L1N}$ and for transistors $Q_{L2A}$ through $Q_{L2N}$ (where N is the number of $Q_{L1}$ or $Q_{L2}$ transistors). By appropriate selection of transistors it is possible to practice the present invention with discrete components. The present invention is ideally suited to be manufactured by monolithic integrated circuit techniques. The present invention is better practiced by building individual transistors on an integrated circuit and coupling them as shown in the circuits of Figure 3 or Figure 8. However, the preferred method of forming these transistors is

EP 0 290 277 B1

to form transistors $Q_{L1A}$ through $Q_{L1N}$ with a single emitter diffusion, a single base diffusion and N collector diffusions formed in the base diffusion, one collector for each transistor. $Q_{L2A}$ through $Q_{L2N}$ are similarly formed. This latter technique clearly reduces the amount of surface area utilized on the integrated circuit for the active load over the prior art technique of adding a large resistance.

An improved low noise integrated active load has been disclosed for bipolar integrated circuits.

**Claims**

1. A low noise integrated active load circuit comprising:
   a. a first terminal ($V_{CC}$);
   b. a second terminal (14);
   c. a third terminal (16);
   d. a first bias resistor ($R_L$) having a first resistor terminal and a second resistor terminal said first resistor terminal coupled to said second terminal;
   e. a first transistor (QL1A-D) having a first collector, a first base and a first emitter, said first emitter coupled to said first terminal and said first collector coupled to said third terminal; and
   f. a plurality of second transistors ($_{QL2A-G}$) each having a second collector, a second base and a second emitter, each of said second emitters coupled to said first terminal, each of said second bases coupled to said first base, to each of said second collectors and to said second resistor terminal.

2. The low noise integrated active load circuit according to claim 1 wherein said first terminal is coupled to a voltage supply.

3. The low noise integrated active load circuit according to claim 1 or 2 wherein said second terminal is coupled to a ground potential.

4. The low noise integrated active load circuit according to claim 1,2 or 3 wherein said third terminal is coupled to an external circuit (12)>

5. The low noise integrated active load circuit according to claim 4 wherein said first transistor and each of said second transistors is a PNP bipolar transistor.

6. The low noise integrated active load circuit according to claim 5 further comprising a third transistor ($Q_{L1A-C}$, fig 8) having a third collector, a third base and a third emitter, said third transistor being a PNP transistor, said third emitter coupled to said first emitter, said third base coupled to said first base and said third collector coupled to said second terminal.

7. The low noise integrated active load circuit according to claim 4 wherein said first transistor and each of said second transistors is an NPN bipolar transistor.

8. The low noise integrated active load circuit according to claim 7 further comprising a third transistor ($Q_{LIA-C}$) having a third collector, a third base and a third emitter, said third transistor being an NPN transistor, said third emitter coupled to said first emitter, said base coupled to said first base and said third collector coupled to said second terminal.

9. The low noise integrated active load circuit according to any preceding claim wherein a second bias resistor ($R_W$) is coupled between said first emitter and said first terminal.

**Patentansprüche**

1. Rauscharmer integrierter aktiver Lastkreis, mit:
   a. einem ersten Anschluß (VCC),
   b. einem zweiten Anschluß (14),
   c. einem dritten Anschluß (16),
   d. einem ersten Vorwiderstand ($R_L$) mit einem ersten Widerstandsanschluß und einem zweiten Widerstandsanschluß, wobei der erste Widerstandsanschluß mit dem zweiten Anschluß verbunden ist,

7

e. einem ersten Transistor (QL1A-D), mit einem ersten Kollektor, einer ersten Basis und einem ersten Emitter, wobei der erste Emitter mit dem ersten Anschluß und der erste Kollektor mit dem dritten Anschluß verbunden sind, und

f. mehreren zweiten Transistoren ($Q_{L2A-G}$) mit zweiten Kollektoren, zweiten Basen und zweiten Emittern, wobei jeder zweite Emitter mit dem ersten Anschluß und jede zweite Basis mit der ersten Basis, mit jedem der Zweiten Kollektoren und mit dem zweiten Widerstandsanschluß verbunden sind.

2. Rauscharmer integrierter aktiver Lastkreis nach Anspruch 1, bei dem der erste Anschluß mit einer Spannungsversorgung verbunden ist.

3. Rauscharmer integrierter aktiver Lastkreis nach Anspruch 1 oder 2, bei dem der zweite Anschluß mit einem Erdpotential verbunden ist.

4. Rauscharmer integrierter aktiver Lastkreis nach einem der Ansprüche 1, 2 oder 3, bei dem der dritte Anschluß mit einem externen Schaltkreis (12) verbunden ist.

5. Rauscharmer integrierter aktiver Lastkreis nach Anspruch 4, bei dem der erste Transistor und jeder der zweiten Transistoren bipolare PNP-Transistoren sind.

6. Rauscharmer intgerierter aktiver Lastkreis nach Anspruch 5, mit weiterhin einem dritten Transistor ($Q_L{}^1{}_{A-C}$,fig. 8) mit einem dritten Kollektor, einer dritten Basis und einem dritten Emitter, wobei der dritte Transistor ein PNP-Transistor ist, der dritte Emitter mit dem ersten Emitter, die dritte Basis mit der ersten Basis und der dritte Kollektor mit dem ersten Anschluß verbunden sind.

7. Rauscharmer integrierter aktiver Lastkreis nach Anspruch 4, bei dem der erste Transistor und jeder der zweiten Transistoren bipolare NPN-Transistoren sind.

8. Rauscharmer integrierter aktiver Lastkreis nach Anspruch 7, mit weiterhin einem dritten Transistor ($Q_{L1A-C}$) mit einem dritten Kollektor, einer dritten Basis und einem dritten Emitter, wobei der dritte Transistor ein NPN-Transistor ist, der dritte Emitter mit dem ersten Emitter, die Basis mit der ersten Basis und der dritte Kollektor mit dem zweiten Anschluß verbunden sind.

9. Rauscharmer integrierter aktiver Lastkreis nach einem der vorangehenden Ansprüche, bei dem ein zweiter Vorwiderstand ($R_W$) zwischen dem ersten Emitter und dem ersten Anschluß angeschlossen ist.

**Revendications**

1. Un circuit intégré à charge active à faible bruit comprenant :
   a. une première borne ($V_{cc}$);
   b. une deuxième borne (14);
   c. une troisième borne (16);
   d. une première résistance de polarisation ($R_L$) qui comprend une première borne de résistance et une deuxième borne de résistance, ladite première borne de résistance étant couplée à ladite deuxième borne;
   e. un premier transistor (QL1A-D) qui comprend un premier collecteur, une première base et un premier émetteur, ledit premier émetteur étant couplé à ladite première borne et ledit premier collecteur étant couplé à ladite troisième borne; et
   f. plusieurs deuxièmes transistors ($Q_{L2A\ à\ G}$) qui comprennent chacun un deuxième collecteur, une deuxième base et un deuxième émetteur, chacun desdits deuxièmes émetteurs étant couplé à ladite première borne, chacune desdites deuxièmes bases étant couplée à ladite première base, à chacun desdits deuxièmes collecteurs et à ladite deuxième borne de résistance.

2. Le circuit intégré à charge active à faible bruit selon la revendication 1 dans lequel la première borne est couplée à une alimentation en tension.

3. Le circuit intégré à charge active à faible bruit selon la revendication 1 ou 2 dans lequel ladite deuxième borne est couplée à un potentiel de masse.

4. Le circuit intégré à charge active à faible bruit selon la revendication 1, 2 ou 3 dans lequel ladite troisième borne est couplée à un circuit externe (12).

5. Le circuit intégré à charge active à faible bruit selon la revendication 4 dans lequel ledit premier transistor et chacun desdits deuxièmes transistors est un transistor bipolaire PNP.

6. Le circuit intégré à charge active à faible bruit selon la revendication 5 comprenant en outre un troisième transistor ($Q_{L1A-C}$, Fig. 8) comprenant un troisième collecteur, une troisième base et un troisième émetteur, ledit troisième transistor étant un transistor PNP, ledit troisième émetteur étant couplé audit premier émetteur, ladite troisième base étant couplée à ladite première base et ledit troisième collecteur étant couplé à ladite deuxième borne.

7. Le circuit intégré à charge active à faible bruit selon la revendication 4 dans lequel ledit premier transistor et chacun desdits deuxièmes transistors est un transistor bipolaire NPN.

8. Le circuit intégré à charge active à faible bruit selon la revendication 7 comprenant en outre un troisième transistor ($Q_{L1A-C}$, Fig. 8) comprenant un troisième collecteur, une troisième base et un troisième émetteur, ledit troisième transistor étant un transistor NPN, ledit troisième émetteur étant couplé audit premier émetteur, ladite base étant couplée à ladite première base et ledit troisième collecteur étant couplé à ladite deuxième borne.

9. Le circuit intégré à charge active à faible bruit selon une revendication précédente quelconque dans lequel une deuxième résistance de polarisation ($R_W$) est couplée entre ledit premier émetteur et ladite première borne.

PRIOR ART

# FIG 1

FIG 3

FIG 4

EP 0 290 277 B1

FIG 5

EP 0 290 277 B1

FIG 6

FIG 2

FIG 7

EP 0 290 277 B1

FIG 8